# EUROPÄISCHE PATENTSCHRIFT

(11) **EP 1 291 117 B1**
(45) Veröffentlichungstag und Bekanntmachung des Hinweises auf die Patenterteilung: **02.11.2006**
(21) Anmeldenummer: 02102306.4
(22) Anmeldetag: 05.09.2002
(51) Int. Cl.: B23K 26/38, B23K 26/06, H05K 3/00

(54) **Verfahren zum Erzeugen einer Bohrung in einem Werkstück mit Laserstrahlung**
Method for producing a hole in a workpiece with a laser beam
Méthode pour produire un perçage dans une pièce à l'aide d'un faisceau laser

(30) Priorität: 07.09.2001 DE 10144008
(43) Veröffentlichungstag der Anmeldung: 12.03.2003
(60) Teilanmeldung: 04030324.0
(73) Patentinhaber: SIEMENS AKTIENGESELLSCHAFT, 80333 München (DE)
(72) Erfinder: Granse, Gerolf, 79689 Maulburg (DE); Lenk, Andreas, 01728 Bannewitz Ot Possendorf (DE)

(56) Entgegenhaltungen:
- EP-A- 0 937 532
- WO-A-01/76808
- US-A- 5 166 493
- US-A- 5 194 713
- US-A- 5 837 964
- US-A- 5 841 099
- US-A- 6 070 813
- PATENT ABSTRACTS OF JAPAN vol. 2000, no. 10, 17. November 2000 (2000-11-17) & JP 2000 202664 A (SUMITOMO HEAVY IND LTD), 25. Juli 2000 (2000-07-25)
- PATENT ABSTRACTS OF JAPAN vol. 006, no. 006 (E-089), 14. Januar 1982 (1982-01-14) & JP 56 129340 A (TOSHIBA CORP), 9. Oktober 1981 (1981-10-09)
- PATENT ABSTRACTS OF JAPAN vol. 017, no. 469 (M-1469), 26. August 1993 (1993-08-26) & JP 05 111784 A (KOMATSU LTD), 7. Mai 1993 (1993-05-07)
- PATENT ABSTRACTS OF JAPAN vol. 014, no. 323 (M-0997), 11. Juli 1990 (1990-07-11) & JP 02 108484 A (SHIBUYA KOGYO CO LTD), 20. April 1990 (1990-04-20)

## Beschreibung

Die Erfindung bezieht sich auf ein Verfahren zum Erzeugen einer Bohrung in einem Werkstück mittels eines Laserstrahls gemäß dem Oberbegriff des Anspruchs 1 (siehe, z.B., US-A-6 070 813).

Das Einbringen von Präzisionsbohrungen, beispielsweise in Stahl oder in anderen metallischen Legierungen, mittels eines Lasers wird seit vielen Jahren industriell angewendet. Beispiele hierfür sind das Herstellen von Kühlungsbohrungen in Turbinenschaufeln oder das Bohren von Benzin- und Dieseleinspritzdüsen. Die Bohrungen haben einen Durchmesser in der Größenordnung von 50 bis 300 µm. Das Bohren von Einspritzdüsen oder Spinndüsen ist jedoch durch extreme Anforderungen an die Geometrie der Bohrungen und deren Reproduzierbarkeit begrenzt, wenn gleichzeitig eine sehr kurze Prozesszeit angestrebt wird. Ebenso ist die Mikrobearbeitung eines schwer zerspannbaren Werkstücks zur Herstellung von Präzisionsschnitten oder zur Erzeugung von Mikrostrukturen in Gleit-oder Laufflächen beispielsweise aus der DE 197 45 280 A1 bekannt. Dort wird ein Laserstrahl vor dem Auftreffen auf ein Werkstück durch drei Module geführt. In dem ersten Modul wird der Laserstrahl um seine Strahlachse gedreht; mittels des zweiten Moduls wird der Auftreffpunkt des Laserstrahls auf dem Werkstück variiert; mittels des dritten Moduls wird der Neigungswinkel des Laserstrahls relativ zur Oberfläche des Werkstücks verändert.

Als Alternative steht zwar bei Durchmessern von 50 bis 150 µm zwar das Verfahren des Erodierens mit einer Elektrode, an die eine Hochspannung angelegt wird, alternativ zur Verfügung; jedoch stößt dieses Verfahren bei einem Aspektverhältnis (Verhältnis von Durchmesser der Bohrung zur Tiefe der Bohrung in dem Material) von 1:10 bis 1:20 an seine Grenzen.

Deswegen haben sich die Forschungsaktivitäten zum Laserbohren in letzter Zeit auf das Trepanier- oder Helixbohren sowie Abwandlungen dieser Bohrverfahren konzentriert. Unter Trepanier- oder Helixbohren versteht man das Durchdringen des Werkstücks, indem der Laserstrahl eine geschlossenen Kontur auf der Oberfläche abfährt, so dass das Material des Werkstücks innerhalb der Kontur herausgetrennt wird. Derartige Laser sind beispielsweise bekannt aus dem Vortrag "Effect of the wavelength on the high-aspect ratio microdrilling of steel with an all-solid-state laser" von Govorkov, S. V.; Slobodtchikov; Wiessner, A. O.; Basting, D.; Conference on Lasers and Electro-Optics (CLEO 2000), Technical Digest. Postconference Edition. TOPS Vol. 39 (IEEE Cat. No. 00CH37088). Derartige Laser sind gütegeschaltet und meist diodengepumpt. Sie verfügen über eine mittlere Leistung von nur wenigen Watt, so dass zur Erreichung einer hohen Präzision meist Prozesszeiten von einer oder mehreren Minuten erforderlich sind.

Andererseits ist es bekannt, dass unter bestimmten Bedingungen das Perkussionsbohren, d. h. Laserstrahl und Werkstück sind ortsfest zu einander angeordnet, mit einem modulierten Laserstrahl und mit Pulsdauern im Bereich von wenigen 0,1 ms Bohrungen mit Durchmessern im Bereich von 20 bis 800 µm erzeugt werden können, die allerdings nur eine geringe Präzision aufweisen. Diese geringe Präzision wird durch die den Bohrprozess bestimmenden Charakteristika des Laserstrahls, d. h. die Pulsdauer und die Pulsenergie des Laserstrahls, bestimmt, die jedoch eine hohe Abtragsrate ermöglichen.

Aus der US-A-6 070 813 ist eine mittels Laser gebohrte Düse an der Spitze eines Injektors bekannt. Ein Injektorgehäuse mit einem Hauptkörperabschnitt und einem Spitzenabschnitt ist offenbart. Der Hauptkörperabschnitt weist eine in ihm ausgebildete Kammer auf, in der Komponenten des Injektors angeordnet sein können. Der Spitzenabschnitt weist eine Düse auf. Die Düse weist einen Durchlass auf, der sich durch diese erstreckt und in Fluidverbindung mit der Kammer steht. Die Düse ist durch ein Verfahren vorbereitet, das den Schritt umfasst: Fokussieren eines Laserstrahls derart, dass sich sein Brennpunkt für eine erste Zeitdauer im wesentlichen auf einer Außenfläche des Spitzenabschnittes befindet, welche ausreichend ist, um den Durchlass zu erzeugen, wodurch die Düse gebildet ist, und Ausschuss wird auf der Peripherie des Durchlasses abgesetzt. Das Verfahren umfasst weiter den Schritt: Erzeugen eines ersten Vordurchlasses, der sich durch den Spitzenabschnitt des Gehäuses erstreckt, wobei der erste Vordurchlass einen ersten im wesentlichen zylindrisch geformten Kanal mit einem ersten Durchmesser festlegt. Das Verfahren umfasst auch weiter den Schritt: Erzeugen eines zweiten Vordurchlasses, der sich durch den Spitzenabschnitt des Gehäuses erstreckt, wobei der zweite Vordurchlass einen zweiten im wesentlichen zylindrisch geformten Kanal mit einem zweiten Durchmesser festlegt, der größer ist als der erste Durchmesser. Das Verfahren umfasst auch noch den Schritt: erneutes Fokussieren des Laserstrahls derart, dass sich sein Brennpunkt für einen Zeitraum oberhalb der Außenfläche befindet, welcher Zeitraum ausreichend ist, um den Ausschuss zu zerkleinern.

Es ist die Aufgabe der Erfindung, ein Verfahren zu schaffen, gemäß dem sich präzise Bohrungen erzeugen lassen.

Die Erfindung ist im Anspruch 1 definiert.

Durch das erfindungsgemäße Verfahren wird der Laserbohrprozess in Teilprozesse zerlegt. Im ersten Schritt wird die Bohrung erzeugt, und in einem zweiten Schritt oder in weiteren Schritten wird der endgültig zu erreichende Durchmesser der Bohrung hergestellt. Aufgrund der unterschiedlichen Prozessdynamik der Teilschritte werden unterschiedliche Strahlquellen gewählt, deren Eigenschaften dem jeweiligen Teilschritt angepasst sind.

Bevorzugte Weiterbildungen des erfindungsgemäßen Verfahrens ergeben sich aus den Unteransprüchen und der nachfolgenden Beschreibung sowie aus dem Ausführungsbeispiel.

Gemäß der Erfindung werden die für den jeweiligen Bearbeitungsschritt erforderlichen Eigenschaften des Laserstrahls optimiert. Der erste Teilprozess ist auf maximalen Materialabtrag, d. h. für das Schrubben, optimiert. Der zweite Teilprozess ist auf Erreichung einer maximalen Präzision und Beschädigungsfreiheit des Werkstücks beim Schlichten zur Erreichung der gewünschten Bohrung oder einer anderen Ausnehmung in dem Werkstück ausgerichtet.

Daher werden bevorzugt zwei unterschiedliche Laser zum Einsatz gebracht, deren Parameter, d. h. die Wellenlänge, die Pulsenergie, die Pulsdauer (der zeitliche Intensitätsverlauf), das Strahlprofil (der räumliche Intensitätsverlauf), die Pulsfolgefrequenz und das Strahlparameterprodukt, für den jeweiligen Bearbeitungsschritt optimiert sind.

Gemäß der Erfindung, erzeugt der für den ersten Teilschritt eingesetzte Laser beispielsweise eine Energie im Bereich zwischen 0,1 J bis zu mehreren Joule. Die Pulswiederholrate liegt bei 1 bis 2 Hz, sie erreicht höchstens 50 bis 100 Hz. Die Pulse haben eine Länge, die im Millisekundenbereich liegt.

Weiter gemäß der Erfindung erzeugt der für den zweite Teilschritt verwendete Laser Pulse mit einer Energie von weniger als 1 mJ bis höchstens 5 mJ. Die Pulsdauer liegt im Nanosekundenbereich oder ist noch kürzer. Der Laser ist bevorzugt ein frequenzverdoppelter oder ein gütegeschalteter Laser (Q - switched laser).

Somit ist es möglich, die Prozessdauer des Laserbohrens erheblich zu verkürzen, aber trotzdem eine Bohrung mit hoher Präzision herzustellen.

Erfindungsgemäß wird dafür Sorge getragen, dass nach Durchführung des ersten Teilprozesses der Laserstrahl beim zweiten Teilprozess wieder exakt auf die Bearbeitungsstelle des ersten Teilprozesses auftrifft. Hierzu dient ein Positioniersystem, mit dem das zu bearbeitende Werkstück in alle drei Raumrichtungen verfahren werden kann. Für die Bewegung des Werkstücks zwischen den Bearbeitungspositionen wird entweder ein 3-Achsen-CNC-System oder ein Steuersystem mit einem Personal Computer zur ein- oder mehrachsigen Bewegung des Werkstücks verwendet. Dabei vollzieht das Werkstück lineare oder auch zirkulare Bewegungen. Auch Bearbeitungsstationen, bei den das Werkstück dreidimensionale Bewegungen vollzieht, können zum Einsatz kommen. Auch die Bearbeitungsstationen selber können linear oder zirkular bewegt werden, ebenso auch dreidimensional.

Bevorzugt wird zur Optimierung und Verkürzung der Prozessdauer der Durchmesser der Bohrung des ersten Teilprozesses nahe an dem in dem zweiten Schritt zu erreichenden Durchmesser gewählt. Bei besonders hohen Anforderungen an die Genauigkeit der Bohrung wird diese nach dem ersten Teilprozess vermessen, bevor der zweite Bearbeitungsschritt erfolgt. Hierzu wird beispielsweise eine Kamera eingesetzt, die auf der Achse des Laserstrahls angeordnet ist. Die Bilder der Kamera werden durch digitale Bildverarbeitungstechniken bearbeitet. Aus den hieraus gewonnenen Informationen ist es möglich, Fehler in der Geometrie der Bohrungen zu korrigieren.

Ein hierfür einsatzfähiges System ist beispielsweise aus der EP 0 937 532 A1 bekannt. Der Laserstrahl wird sowohl über die Positionierung des Werkstücks als auch mittels einer Strahlnachführung in der gewünschten Weise auf das Werkstück ausgerichtet. Dazu werden beispielsweise bekannte Systeme zur Strahlstabilisierung eingesetzt, wie zum Beispiel Kippspiegel.

Zur Bewegung des Laserstrahls während des zweiten Bearbeitungsschritts wird ein Kippspiegelsystem (Galvoscanner) eingesetzt, wie es aus Laserbeschriftungssystemen bekannt ist. Das Kippspiegelsystem weist eine Planfeldoptik oder eine Einrichtung zur Strahldrehung auf, d. h. einen Strahlrotator. Das Kippspiegelsystem hat den Vorteil, dass mit ihm auch nicht-kreisförmige Bewegungen ausgeführt werden können.

Der Strahlrotator hat den Vorteil, dass er auch bei höheren Geschwindigkeiten eine Kreisbahn mit hoher Wiederholgenauigkeit und Rundheit abfährt. Darüber hinaus ist die Anzahl der Überfahrten des Laserstrahls über das Werkstück ebenso vorgebbar wie die Nachführung des Brennpunkts des Laserstrahls, wobei die Lage des Brennpunkts schrittweise oder kontinuierlich geändert wird.

Neben zylindrischen Bohrungen lassen sich mit dem erfindungsgemäßen Verfahren auch konische oder teilweise konische Bohrungen realisieren. Dabei wird die Geometrie der Bohrungen durch eine synchronisierte Taumelbewegung beeinflussen. Hierbei führt der Laserstrahl relativ zum zu bearbeitenden Werkstück eine Taumelbewegung aus und durchläuft dabei eine Kegelmantelfläche. Durch die Taumelbewegung wird das Längsprofil der Bohrung exakt definiert. Der Laserstrahl wird zusätzlich synchron mit der Taumelbewegung um die eigene Achse gedreht. Daher wirkt zu jedem Zeitpunkt die gleiche Laserstrahlstelle in azimutaler Richtung auf das Werkstück ein. Ein unrunder Laserstrahlquerschnitt wird durch die Taumelbewegung egalisiert. Es entstehen extrem runde Bohrungsquerschnitte. Die Erzeugung eines taumelnden Laserstrahls durch eine drehenden Prismenanordnung ist aus der US 4 822 974 bekannt.

Eine andere Möglichkeit der Beeinflussung der Form der Bohrung besteht in der Nachführung des Brennpunkts des Laserstrahls.

Auch die Polarisation des Laserlichts hat einen Einfluss auf die Entstehung der Bohrungsgeometrie. Entweder wird der Einfluss der anfangs in dem Laserstrahl vorhandenen Polarisation dadurch unterdrückt, dass der Laserstrahl zirkular polarisiert wird, etwa durch eine N/4 - Platte. Alternativ wird die Polarisation des Lichts gezielt ausgenutzt, indem beispielsweise der Laserstrahls während des zweiten Teilschritts so entlang der Wandung der Bohrung verfahren wird, dass die Polarisationsrichtung stets in radialer Richtung verläuft.

Wenn bei diesem Bearbeitungsschritt der Laserstrahl selbst bewegt wird, ergibt sich eine derartige Polarisationsrichtung nach einmaliger richtiger Justierung der Polarisationsebene des Strahls bezüglich der Wandung automatisch. Wenn das Werkstück bewegt wird, muss die Polarisationsebene des Laserstrahls synchron mitgeführt werden, was mittels einer sich drehenden N/2- Platte möglich ist. In jedem Fall ist es möglich, den Polarisationsvektor in einem definierten Winkel zur Bahntangente des Laserstrahls einzustellen.

Das erfindungsgemäße Verfahren ist derart ausgeführt, dass der erste Schritt über einen kürzeren Zeitraum durchgeführt wird als der zweite oder ein weiterer Schritt.

In einer bevorzugten Variante werden der Laserstrahl und das Werkstück wenigstens während eines der Schritte zur Herstellung der Bohrung relativ zueinander bewegt, wobei entweder der Laserstrahl oder das Werkstück oder beide bewegt werden.

Ebenfalls bevorzugt wird der Bewegung des Laserstrahls gegenüber dem Werkstück eine synchrone taumelnde Bewegung überlagert.

In einer geeigneten Ausführungsform wird die Lage des Brennpunkts des Laserstrahls während des ersten oder des zweiten oder eines weiteren folgenden Schritts schrittweise oder kontinuierlich verändert.

Die Erfindung **lässt** sich **ausführen** auf einer Vorrichtung zum Erzeugen einer Bohrung in einem Werkstück mittels Laserstrahlung. **Die Vorrichtung umfasst** einen ersten und einen zweiten Laser, die sich mindestens durch einen Parameter unterscheiden.

Jedem der Laser **sind** jeweils eine eigene Bearbeitungsoptik und ein eigenes Handlingsystem zugeordnet. Das Handlingsystem ist beispielsweise ein Kreuztisch mit Verschiebungselementen, insbesondere eine CNC-Einheit zum Verschieben des Werkstücks.

Bei den für das Handlingsystem eingesetzten Komponenten wird eine Wiederholgenauigkeit bei der Bearbeitung des Werkstücks von mehr als 2 µm, insbesondere mehr als 1 µm, angestrebt.

In einer Weiterbildung hat die Vorrichtung ein Messmikroskop einschließlich einer Bildauswertungseinheit, um das Bearbeitungsergebnis aus dem ersten Teilprozess exakt zu lokalisieren.

Eine Überwachungseinheit zur Überwachung der Strahllage des Laserstrahls **kann ebenfalls eingesetzt werden.**

In einer **weiteren** Ausführung der Vorrichtung ist eine einem Objektiv der Bearbeitungsoptik nachgeordnete Scaneinrichtung oder eine Planfeldoptik oder ein Strahlrotator vorgesehen.

**Dabei kann** eine rotierende Planplatte oder eine wenigstens zwei Spiegel aufweisende Spiegelanordnung zur Erzeugung einer Taumelbewegung vorhanden **sein. Oder die** Spiegelanordnung **umfasst** drei oder vier Spiegel.

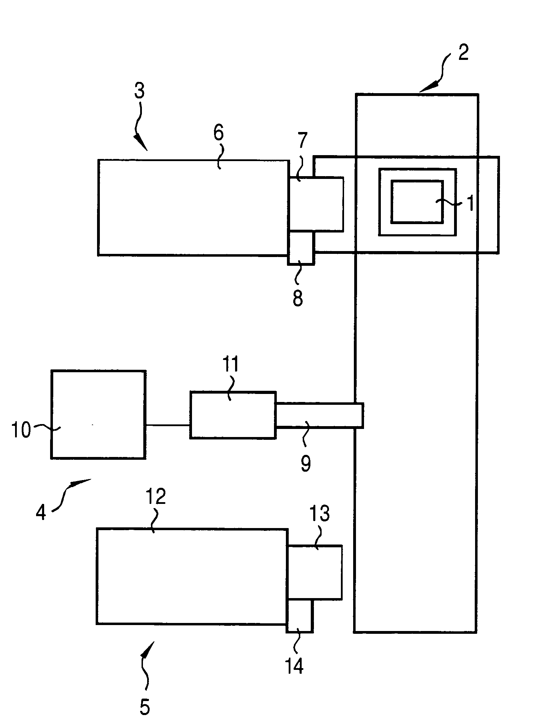

Nachstehend wird die Erfindung in einem Ausführungsbeispiel näher erläutert. Die einzige Figur zeigt eine schematische Darstellung einer Vorrichtung **zum Durchführen des erfindungsgemäßen Verfahrens.**

Ein Werkstück 1 aus Stahl mit einer Dicke von 1 mm wird über eine 3-Achsen-CNC-Einheit 2 transportiert. Die Einheit 2 weist drei Stationen 4, 5 und 6 auf. Die Station 3 umfasst einen Nd:YAG-Laser 6 mit einer Bearbeitungsoptik 7, die beispielsweise eine Brennweite von 100 mm hat. Der Laser 6 emittiert einen Pulszug mit Pulslängen von 0,3 ms und einer Gesamtenergie von 1 J. Nach 0,5 s wird ein zweiter Pulszug emittiert, wobei die Lage des Brennpunkts um 1 mm entsprechend der Dicke des Werkstücks 1 auf 101 mm verschoben wird. Auf diese Weise wird eine Bohrung mit einem Durchmesser von 250 µm erzeugt. Die Abweichung von der Zylinderform beträgt hierbei +/- 5 %. Mit einer Überwachungseinheit 8 wird die Position des Laserstrahls bezüglich des Werkstücks überwacht. Falls diese von der Soll-Position abweicht, wird die Einheit 2 mit dem Werkstück 1 entsprechend nachgeführt.

Danach positioniert die Einheit 2 das Werkstück 1 vor die Station 4, an der die Position der Bohrung genau bestimmt wird. Hierzu dient ein Mikroskop 9 mit einer an das Mikroskop 9 angeschlossenen Bildauswertungseinheit 10. Das Mikroskop 9 vergrößert ein von einer CCD-Kamera 11 erzeugtes Bild der Bohrung um das Zwanzig- bis Fünfzigfache. Falls sich dabei zeigt, dass der Laserstrahl nicht die Soll-Position einnimmt, wird die Einheit 2 bezüglich der Station 2 nachjustiert. Bei unzulässigen Abweichungen wird die Strahllage des Lasers 6 durch die Überwachungseinheit 8 kontrolliert.

Unter Berücksichtigung der erfassten Position des Werkstücks 1 wird dieses anschließend zu der Station 5 bewegt. Dort ist ein gütegeschalteter und frequenzverdoppelter Festkörperlaser 12 vorhanden. Ihm ist eine Bearbeitungsoptik 13 zugeordnet. Auf einer durch eine Überwachungseinheit 14 erfassten Strahllage wird das Werkstück 1 ausgerichtet.

Die Bearbeitungsoptik 13 umfasst eine rotierende Keilplatte zur Erzeugung einer Trepanierbewegung, d. h. einer Kreisbewegung, und eine korrigierte Sammellinse mit einer Brennweite von 100 mm. Die Bearbeitungsoptik 13 führt den Laserstrahl auf einer Kreisbahn um den Mittelpunkt der Bohrung herum. Auf diese Weise erhält die Bohrung in dem Werkstück 1 ihre endgültige Form; dabei wird nach einer Prozessdauer von weniger als 30 s eine Zylinderformabweichung der Bohrung von +/- 1 % erzielt.

Die Bearbeitungsoptiken 7, 13 umfassen entweder eine hinter einer Sammellinse angeordnete Scaneinheit (post-objective Scanning), die gegen einander bewegliche Spiegel aufweist; oder es ist eine f- oder eine telezentrische Planfeldoptik vorgesehen. Alternativ lässt sich ein Strahlrotator einsetzen, der entweder eine Anordnung von zwei, drei oder vier Spiegeln aufweist, oder aus einer rotierenden Keilplattenanordnung besteht.

Durch die Erfindung wird ein Verfahren und zum Erzeugen von Bohrungen in einem Werkstück 1 mittels Laserstrahlung geschaffen. Dabei wird mit einem ersten Laser 6 in einem ersten Schritt eine Bohrung mit einem ersten Durchmesser gebohrt, der geringer ist als der endgültig zu erreichende Durchmesser. Dieser wird dann mit einem zweiten Laser 12 in einem zweiten Schritt oder in weiteren Schritten auf den zu erreichenden Durchmesser aufgeweitet.

## Patentansprüche

1. Verfahren zum Erzeugen einer Bohrung in einem Werkstück (1) mittels eines Laserstrahls,
wobei in einem ersten Schritt eine Bohrung mit einem ersten Durchmesser gebohrt wird, der geringer ist als der endgültig zu erreichende Durchmesser, wobei in einem zweiten Schritt oder in weiteren Schritten die Bohrung auf den zu erreichenden Durchmesser aufgeweitet wird und wobei der erste Schritt über einen kürzeren Zeitraum durchgeführt wird als der zweite oder ein weiterer Schritt,
**dadurch gekennzeichnet, dass** der Laserstrahl für den ersten Schritt eine Energie im Bereich zwischen 0,1 bis zu mehreren Joules, eine Pulswiederholrate im Bereich zwischen 1 bis zu 100 Hz und eine Pulslänge im Millisekundenbereich aufweist, wobei der Laserstrahl für den zweiten oder die weiteren Schritte eine Energie von weniger als 1 mJ bis höchstens 5 mJ, eine Pulsdauer im Nanosekundenbereich oder kürzer aufweist, so dass die Bohrung im ersten Schritt durch Schrubben und im zweiten Schritt oder den weiteren Schritten durch Schlichten und/oder polieren gebildet wird.

2. Verfahren nach Anspruch 1, **dadurch gekennzeichnet, dass** der Laserstrahl und das Werkstück (1) wenigstens während eines der Schritte zur Herstellung der Bohrung relativ zueinander bewegt werden, wobei entweder der Laserstrahl oder das Werkstück (1) oder beide bewegt werden.

3. Verfahren nach Anspruch 2, **dadurch gekennzeichnet, dass** der Bewegung des Laserstrahls gegenüber dem Werkstück (1) eine synchrone taumelnde Bewegung überlagert wird.

4. Verfahren nach einem der Ansprüche 1 bis 3, **dadurch gekennzeichnet, dass** die Lage des Brennpunkts des Laserstrahls während des ersten oder des zweiten oder eines weiteren folgenden Schritts schrittweise oder kontinuierlich verändert wird.

5. Verfahren nach einem der Ansprüche 1 bis 4, **dadurch gekennzeichnet, dass** der Bewegung des Laserstrahls beim zweiten oder einem weiteren Schritt eine Drehung der Polarisationsebene überlagert wird.

## Claims

1. Method for creating a drill hole in a workpiece (1) by means of a laser beam,
whereby in a first step a drill hole is drilled with a first diameter which is less than the final diameter to be achieved, whereby in a second step or in further steps the drill hole is expanded to the diameter to be achieved and whereby the first step is implemented over a shorter period than the second or a further step, **characterised in that** for the first step the laser beam has an energy in the range between 0.1 and several joules, a pulse repetition rate in the range between 1 and 100 Hz and a pulse length which can be measured in milliseconds, whereby for the second or the further steps the laser beam has an energy of less than 1 mJ up to a maximum of 5 mJ, and a pulse duration which can be measured in nanoseconds or shorter, so that the drill hole is formed in the first step by rough-machining and in the second step or the further steps by finish-machining and/or polishing.

2. Method according to claim 1, **characterised in that** the laser beam and the workpiece (1) are moved relative to each other at least during one of the steps to produce the drill hole, whereby either the laser beam or the workpiece (1) or both are moved.

3. Method according to claim 2, **characterised in that** a synchronous tumbler motion is overlaid over the motion of the laser beam in respect of the workpiece (1).

4. Method according to one of claims 1 to 3, **characterised in that** the position of the focal point of the laser beam is gradually or continuously changed during the first or the second or a further following step.

5. Method according to one of claims 1 to 4, **characterised in that** a rotation of the polarisation plane is overlaid over the motion of the laser beam in the second or a further step.

## Revendications

1. Procédé pour produire un perçage dans une pièce (1) au moyen d'un rayon laser,
dans lequel, dans une première étape, on perce un perçage d'un premier diamètre qui est plus petit que le diamètre définitif à atteindre, tandis que, dans une deuxième étape ou dans d'autres étapes, le perçage est élargi au diamètre à atteindre, et dans lequel la première étape est exécutée dans un temps plus court que la deuxième étape ou qu'une autre étape, **caractérisé en ce que**, pour la première étape, le rayon laser présente une énergie de l'intervalle compris entre 0,1 et plusieurs joules, une fréquence de répétition des impulsions comprise dans l'intervalle entre 1 et 100 Hz et une longueur d'impulsions de l'ordre de la milliseconde, et **en ce que**, pour la deuxième étape ou pour les autres étapes, le laser présente une énergie de moins de 1 mJ jusqu'à 5 mJ au maximum, une durée d'impulsion de l'ordre de la nanoseconde ou plus courte, de sorte que le perçage est formé par dégrossissage dans la première étape, tandis que, dans la deuxième étape ou dans les autres étapes, il est formé par lissage et/ou polissage.

2. Procédé selon la revendication 1, **caractérisé en ce que** le rayon laser et la pièce (1) sont déplacés l'un par rapport à l'autre, au moins pendant une des étapes de production du perçage, où soit le rayon laser, soit la pièce (1), soit les deux est ou sont déplacés.

3. Procédé selon la revendication 2, **caractérisé en ce qu'**au déplacement du rayon laser par rapport à la pièce (1), est superposé un mouvement de nutation synchrone.

4. Procédé selon une des revendications 1 à 3, **caractérisé en ce que** la position du foyer du rayon laser est modifiée par pas successifs ou en continu pendant la première étape ou pendant la deuxième étape ou pendant une autre étape suivante.

5. Procédé selon une des revendications 1 à 4, **caractérisé en ce que**, dans la deuxième étape ou dans une autre étape, une rotation du plan de polarisation est superposée au mouvement du rayon laser.
